# FASCICULE DE BREVET EUROPEEN

(11) **EP 0 774 780 B1**
(45) Date de publication et mention de la délivrance du brevet: **31.07.2002**
(21) Numéro de dépôt: 96402439.2
(22) Date de dépôt: 14.11.1996
(51) Int. Cl.: H01L 21/66

(54) **Procédé de fabrication d'un dispositif de micro-électronique comportant sur un substrat une pluralité d'éléments interconnectés**
Herstellungsmethode einer mikroelektronischen Schaltung mit vielen Verbindungselementen auf einem Substrat
Manufacturing method of a microelectronic device having on a substrate a plurality of interconnect elements

(30) Priorité: 17.11.1995 FR 9513658
(43) Date de publication de la demande: 21.05.1997
(73) Titulaire: COMMISSARIAT A L'ENERGIE ATOMIQUE, 75015 Paris (FR)
(72) Inventeur: Caillat, Patrice, 38130 Echirolles (FR)
(74) Mandataire: Dubois-Chabert, Guy

(56) Documents cités:
- EP-A- 0 481 703
- WO-A-82/02603
- DE-A- 1 439 648
- FR-A- 2 558 989
- US-A- 3 585 712

## Description

### Domaine technique

La présente invention concerne un procédé de fabrication d'un dispositif de micro-électronique comportant sur un substrat une pluralité d'éléments interconnectés.

Elle trouve de façon générale des applications dans le domaine de la micro-électronique, par exemple, pour la fabrication de circuits intégrés dont la fonction finale est la somme des fonctions d'éléments individuels ou de circuits intégrés dont les éléments sont interconnectés au cours de leur fabrication pour permettre la réalisation d'un dépôt électrolytique collectif.

Ainsi, l'invention s'applique par exemple à la fabrication de dispositifs équipés d'une pluralité d'électrodes et servant de support pour effectuer des réactions électrochimiques collectives.

L'invention s'applique aussi à la réalisation de détecteurs "intelligents" intégrant sur un même substrat des capteurs sensibles et des circuits de contrôle associés à ces capteurs.

L'invention s'applique aussi à la fabrication de mémoires électroniques.

### Etat de la technique antérieure

Dans le domaine de la microélectronique et en particulier pour la réalisation de circuits intégrés de grande complexité comportant un grand nombre d'éléments, ces circuits intégrés sont subdivisés en cellules regroupant respectivement un certain nombre d'éléments. Ce type de structure permet d'augmenter les rendements de fabrication en introduisant une redondance des cellules au moins pour une partie de la fonction du circuit intégré.

Lorsque sa fabrication est achevée un tel circuit intégré est "reconfiguré". Cette opération consiste à interconnecter les cellules valides et à isoler les cellules comportant un défaut.

A ce sujet, on peut se reporter au document (1) dont la référence est donnée à la fin de la présente description.

Pour réaliser une reconfiguration d'un circuit, il est possible soit d'y ajouter des pistes conductrices qui relient des cellules dont on a vérifié la validité, soit de détruire des pistes conductrices reliant des cellules valides à des cellules invalides.

La jonction des cellules valides et l'isolation des cellules invalides peuvent être réalisées notamment par des outils fonctionnant avec une source laser programmable. Ces outils permettent soit d'effectuer un dépôt localisé d'un matériau conducteur pour former une piste de jonction, soit de détruire localement une piste conductrice pour l'interrompre. On peut se référer à ce sujet au document (2) dont la référence est donnée à la fin de la présente description.

La reconfiguration des circuits peut aussi être réalisée par sciage mécanique des lignes de connexions électriques à éliminer.

Toutefois, les équipements mécaniques de coupure ainsi que les équipements à laser sont d'un coût élevé et un investissement dans un tel type de matériel ne peut être justifié que pour la production de circuits intégrés en très grande série.

De plus, les techniques de reconfiguration de l'art antérieur nécessitent une étape supplémentaire au procédé de fabrication des circuits intégrés.

Tel est le cas, par exemple, dans un procédé décrit dans le document (3). Ce procédé suppose la fabrication d'un masque d'insolation spécial avec des ouvertures dont la répartition est dictée par la répartition des éléments valides, propre à chaque circuit traité.

Ainsi, la présente invention a pour but de proposer un procédé de fabrication d'un dispositif microélectronique intégrant l'étape de reconfiguration et qui ne nécessite pas un équipement spécialement prévu à cet effet.

Un autre but est de proposer un procédé permettant de façon simple et peu coûteuse de réaliser et de reconfigurer un circuit intégré.

Un autre but est de proposer un procédé adapté à la fabrication de dispositifs spécifiques de microélectronique.

Un but de l'invention est aussi de proposer un procédé de reconfiguration ne nécessitant pas d'étape supplémentaire dans les procédés lithographiques de dépôts et de gravure utilisés pour la fabrication des dispositifs de microélectronique.

### Exposé de l'invention

Pour atteindre notamment les buts mentionnés ci-dessus, l'invention a plus particulièrement pour objet un procédé de fabrication d'un dispositif de microélectronique comportant sur un substrat une pluralité d'éléments actifs interconnectés. Conformément à l'invention le procédé comporte les opérations successives suivantes :
a) réalisation de cellules d'éléments sur un substrat, chaque cellule comportant au moins un élément, les cellules d'éléments étant isolées électriquement les unes des autres et au moins un élément de chaque cellule présentant au moins un terminal de connexion pour la connexion des cellules d'éléments selon un plan de connexion déterminé,
b) test des cellules pour distinguer des cellules valides dont les éléments sont valides, des cellules comportant au moins un élément invalide.
c) formation par photolithographie de bandes de jonction (40a, 40b, 40c, 44a, 44b, 44c) en un matériau conducteur électrique reliant au moins un terminal de connexion d'au moins un élément d'une cellule valide avec au moins un élément d'une autre cellule valide, les bandes de jonction étant formées dans des champs d'insolation valides, sensiblement identiques (132, 136, 138), chaque champ d'insolation valide recouvrant respectivement une cellule valide et comprenant au moins une zone marginale (50, 52) de recouvrement avec au moins un champ voisin, la zone de recouvrement étant insolée à un motif de lithographie correspondant à au moins une portion de bande de jonction de sorte que chaque bande de connexion est réalisée selon un motif correspondant à la juxtaposition et au recouvrement partiel de motifs de champs d'insolation voisins.

Au sens de la présente invention, on entend par élément aussi bien un élément actif (par exemple un transistor, un microprocesseur, une cellule mémoire,...) qu'un élément passif (par exemple une électrode, une structure micro-usinée,...). La notion d'élément englobe également aussi bien un élément individuel qu'un ensemble d'éléments actifs et/ou passifs.

Par ailleurs, on entend par élément valide un élément ne présentant pas de défaut rédhibitoire par rapport à un traitement collectif ultérieur des éléments du dispositif.

A titre d'exemple, un tel défaut rédhibitoire peut être un court-circuit dans l'élément qui relie son alimentation à sa masse et qui met en défaut tous les éléments qui lui sont reliés.

Chaque cellule fabriquée sur le substrat peut comporter un ou plusieurs éléments.

Dans la réalisation de dispositifs de microélectronique de taille importante, lors des étapes de photolithographie pour la réalisation des composants, l'ensemble de la tranche de substrat n'est généralement pas insolée de façon simultanée. Des portions du substrat sont successivement insolées à travers des masques comportant des motifs correspondant aux composants ou parties de composant à réaliser. Des portions identiques du substrat sont insolées successivement en effectuant un déplacement relatif du substrat par rapport au(x) masque(s) et au système optique d'insolation. Aussi, dans la suite du texte on désigne par champ une telle portion du substrat correspondant à une région d'insolation à travers un masque de photolithographie.

Le test des cellules peut être réalisé en appliquant ou en mesurant des tensions de contrôle sur des plots de test spécialement prévu à cet effet.

De façon préférentielle, le test des cellules peut comporter le test individuel de chaque élément, notamment lorsque les cellules comportent plusieurs éléments. Une cellule est considérée valide lorsque tous ses éléments sont valides.

Au cours de l'étape a) sont réalisés les éléments correspondant à chaque cellule. Toutefois, comme ces cellules sont juxtaposées il n'existe pas de contact électrique entre les éléments des différentes cellules, et, en particulier, il n'existe pas de contact électrique entre les terminaux de connexion des éléments de cellules différentes.

Les champs valides de l'opération c) qui sont sensiblement superposés aux cellules sont de taille légèrement supérieure à celles-ci. Il existe ainsi un recouvrement entre des champs voisins.

Dans la partie de recouvrement, située dans une zone marginale (c'est-à-dire périphérique) des champs valides, sont réalisées une ou plusieurs portions de bande de jonction pour interconnecter certains éléments des cellules correspondant aux champs valides voisins.

Les portions de bandes de jonction peuvent relier en particulier les terminaux de connexion des éléments correspondants.

Selon une mise en oeuvre particulière la fabrication des bandes de jonction peut comporter :
- le dépôt sur l'ensemble du substrat d'une couche de matériau conducteur électrique recouvrant les éléments,
- le dépôt d'une couche de résine photosensible sur la couche de matériau conducteur électrique,
- l'insolation de la résine dans lesdits champs valides, à travers un masque, créant pair recouvrement des champs valides des motifs correspondant aux bandes de jonction,
- le développement de la résine, pour l'éliminer en dehors de régions correspondant aux bandes de jonction,
- la gravure de la couche de matériau conducteur en laissant subsister les bandes de jonction.

Les bandes de jonction peuvent aussi être définies par pelage (appelé "lift off" en terminologie anglo-saxonne).

Dans ce cas, leur fabrication comporte :
- le dépôt sur l'ensemble du substrat d'une couche de résine photosensible,
- l'insolation de la résine dans lesdits champs valides, à travers un masque, créant par recouvrement des champs valides des motifs correspondant aux bandes de jonction,
- le développement de la résine pour l'éliminer dans des régions correspondant aux bandes de jonction,
- le dépôt sur l'ensemble du substrat d'une couche de matériau conducteur électrique, et
- l'attaque de la résine et l'élimination par pelage du matériau conducteur électrique en dehors des régions correspondant aux bandes de jonction.

De façon avantageuse grâce à l'invention, l'insolation de la résine dans les champs peut être faite champ après champ avec un unique masque prédéterminé. Le choix d'interconnecter ou non une cellule ne nécessite ainsi pas de modification du masque, mais est effectué simplement en insolant ou non les champs correspondants. En particulier, seuls les champs valides correspondant aux cellules valides sont insolés.

Dans une réalisation particulière des cellules, chaque cellule peut comporter des électrodes et éventuellement un circuit de multiplexage des électrodes.

Dans le cas où les éléments comportent une pluralité de niveaux conducteurs ceux-ci sont formés en général lors de plusieurs étapes de photolithographie de dépôt et de gravure.

Toutefois, selon un aspect avantageux de l'invention, il est possible de réaliser un des niveaux de matériau conducteur des éléments simultanément avec les bandes de jonction dans lesdits champs.

Grâce à cette caractéristique le procédé de "reconfiguration" de l'invention n'implique pas une étape de lithographie de dépôt et de gravure supplémentaire par rapport à une réalisation ordinaire des éléments.

Lorsque le dispositif de microélectronique à réaliser comporte une pluralité de cellules d'éléments identiques, les éléments de ces cellules, ou les cellules, peuvent être réalisés de façon avantageuse par photorépétition de champ comportant des motifs de lithographie. Dans les cas où les cellules (qu'elles soient identiques ou différentes) ne sont pas réalisées par photorépétition, celles-ci sont formées en utilisant des étapes de lithographie insolant l'ensemble des cellules à travers un masque.

La photorépétition de champs sur un substrat consiste en l'insolation successive des différents champs à travers un même masque. Le masque et un dispositif optique de projection sont déplacés à cet effet au-dessus de la plaque de substrat dans un appareil désigné usuellement par "steppeur".

D'autres caractéristiques et avantages de la présente invention ressortiront de la description qui va suivre en référence aux figures des dessins annexés, donnée à titre purement illustratif et non limitatif.

### Brève description des figures

- la figure 1 montre des premiers champs de photolithographie sur un substrat pour la réalisation de cellules d'un dispositif de microélectronique, conformément à l'invention,
- la figure 2 montre des deuxièmes champs de photolithographie sur le substrat pour la réalisation de bandes de jonction entre des éléments des cellules du dispositif, conformément à l'invention.

### Description détaillée d'un mode de mise en oeuvre de l'invention

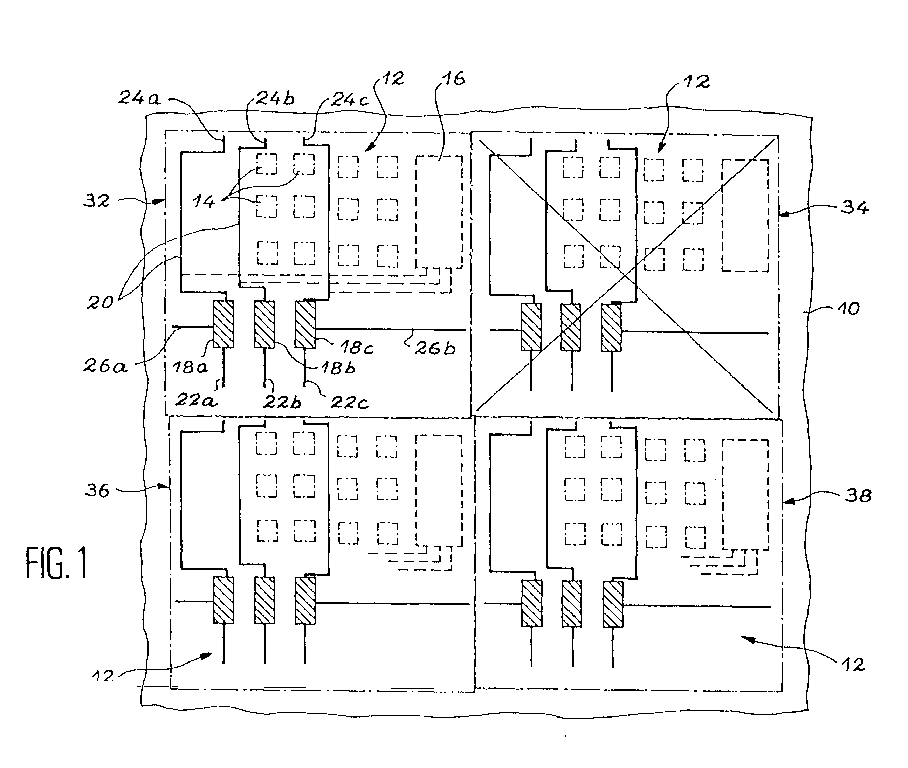

La figure 1 donne un exemple de dispositif de microélectronique destiné à être traité conformément à l'invention.

Le dispositif comporte sur un substrat 10 une pluralité de cellules 12 identiques les unes aux autres réalisées dans cet exemple par photorépétition. Chaque cellule peut comporter un ou plusieurs éléments.

Dans l'exemple de la figure 1, chaque cellule 12 comporte un jeu d'électrodes 14 (non encore réalisées) et un circuit 16 d'adressage (ou multiplexage) des électrodes.

Chaque cellule comporte également des plots de test 18 et des pistes conductrices 20 dont les extrémités forment des terminaux de connexion des éléments et en particulier du circuit 16.

Les différents éléments, actifs ou passifs de chaque cellule sont réalisés sur différents niveaux conducteurs au cours de différentes étapes de lithographie, de dépôt et de gravure.

Ainsi, la figure 1 correspond à l'étape de réalisation des pistes conductrices et des plots de test.

L'emplacement des électrodes 14 et du circuit 16 est représenté en trait discontinu pour signifier que ces éléments sont réalisés respectivement lors d'une étape ultérieure et lors d'étapes antérieures.

Comme les électrodes et les circuits d'adressage 16 ne sont pas réalisés simultanément avec les plots de test et ne se situent donc pas sur un même niveau conducteur, des liaisons électriques entre ces éléments n'apparaissent pas de façon détaillée sur la figure.

Comme le montre la figure 1, chaque cellule 12 correspond à un premier champ 32, 34, 36, 38 du substrat.

Chaque champ correspond à une plage d'insolation du substrat à travers un masque présentant des motifs correspondant aux éléments à réaliser sur un niveau conducteur donné lors d'une étape de photolithographie.

Lors de la réalisation d'un même niveau de lithographie, l'ensemble de la plaque est, par exemple, recouverte d'une couche de matériau à mettre en forme et d'une couche de résine photosensible.

La résine photosensible est ensuite insolée successivement dans chaque champ à travers un même masque pour répéter dans chaque champ des motifs d'insolation identiques. La résine est développée et le matériau à mettre en forme est éliminé dans les régions non protégées par la résine, pour laisser subsister des éléments selon les motifs du masque. Il s'agit dans le cas de la figure 1, par exemple des plots 18a, 18b, 18c et des pistes conductrices 20, qui sont réalisées dans une avant-dernière étape de photolithographie du procédé. La résine est ensuite éliminée.

Comme le montre la figure 1, les éléments de la cellule tels que le circuit d'adressage 16, les électrodes 14 et les plots de test 18a, 18b, 18c et les pistes conductrices 20 sont réalisés dans des champs 32, 34, 36, 38 sensiblement juxtaposés. Ainsi, les éléments de chaque cellule sont électriquement isolés des éléments des cellules voisines.

On peut noter que les terminaux] de connexion des pistes conductrices s'étendent dans une région périphérique des premiers champs sans toutefois atteindre le bord de ces champs.

Après la réalisation des éléments et notamment des plots de test, chaque élément, en l'occurrence chaque circuit 16, est testé en appliquant ou en mesurant sur les plots de test de chaque cellule un jeu approprié de tensions de test.

Le test des éléments des cellules est facilité en raison de l'isolation électrique de ces cellules les unes par rapport aux autres.

Dans la suite de la description, on considère que les éléments des cellules correspondant' aux champs 32, 36 et 38 sont révélés valides lors du test et qu'au moins un des éléments de la cellule correspondant au champ 34 présentent un court-circuit masse/alimentation rendant l'ensemble de la cellule non valide.

Les éléments de la cellule correspondant au champ 34 sont donc considérés comme invalides.

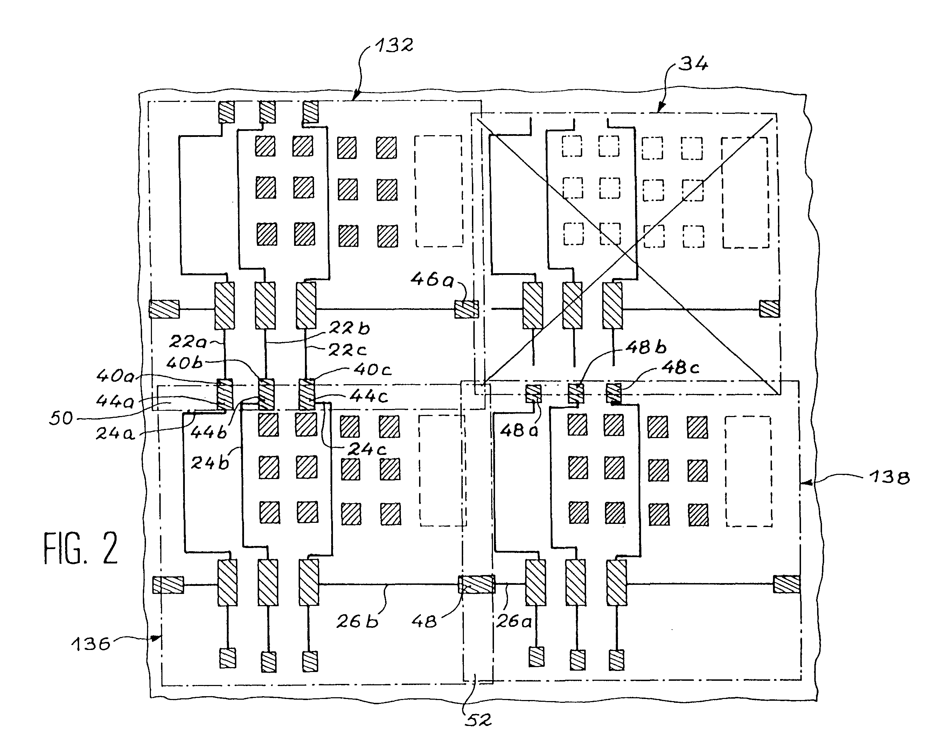

La figure 2 correspond à l'interconnexion des cellules (reconfiguration) du dispositif. Elle consiste à relier entre eux certains éléments valides correspondant à des cellules valides selon un plan de connexion prédéterminé.

Le plan de connexion comporte par exemple la mise en parallèle de bornes d'entrée ou de sortie correspondantes respectivement de chaque élément actif valide.

La "reconfiguration" est réalisée dans cet exemple lors d'une dernière étape de photolithographie d'un dernier niveau conducteur.

Cette étape permet de former dans le dernier niveau des bandes de connexion repérées par la référence 40a, 40b, 40c, 44a, 44b, 44c.

La dernière étape de lithographie est réalisée dans des deuxièmes champs 132, 136, 138 qui recouvrent sensiblement les champs 32, 36 et 38.

Les champs 132, 136 et 138 comportent par ailleurs avec les champs voisins une zone de recouvrement. Ainsi les champs 132 et 136 ont en commun une zone de recouvrement 50 et les champs 136 et 138 ont une zone de recouvrement mutuel 52.

Le masque de photolithographie correspondant à la dernière étape comporte pour chaque terminal de connexion un motif correspondant à une portion d'une bande de jonction destinée à relier le terminal de connexion à un terminal d'une cellule voisine selon le plan de connexion.

Au moins une partie de chaque motif s'étend dans la zone marginale des deuxièmes champs qui correspond à la zone de recouvrement avec un champ voisin. Ainsi la partie du motif vient recouvrir une partie correspondante d'un motif d'une portion de bande de jonction d'un deuxième champ voisin.

Ainsi lorsque deux deuxièmes champs voisins présentant une zone de recouvrement sont successivement insolés à travers un masque avec des motifs correspondant aux bandes de jonction, lors de la dernière étape de photolithographie, une ou plusieurs bandes de jonction reliant les terminaux de connexion sont formées. Chaque bande de connexion est réalisée selon un motif correspondant à la juxtaposition et au recouvrement partiel des motifs correspondent aux portions de la bande sur les champs voisins.

A titre d'illustration des bandés 40a, 44a ; 40b, 44b et 40c, 44c relient respectivement les terminaux 22a, 22b, 22c du champ 132 aux terminaux 24a, 24b, 24c du champ 136 et une bande 48 relie les terminaux 26b et 26a des champs 136 et 138.

Chaque bande de connexion comporte deux portions de bande correspondant à des motifs de deux champs voisins qui présentent un recouvrement.

Les terminaux 22a et 24a des champs 132 et 138 sont reliés par exemple par une bande de jonction comportant deux portions 40a et 44a formées respectivement par des motifs de photolithographie des deux champs 132 et 138 qui se recouvrent au moins partiellement dans la zone 50.

La partie du substrat correspondant au premier champ 34 est ignorée lors de la dernière étape de lithographie. Elle n'est pas insolée et le matériau conducteur y est éliminé dans sa totalité. Aucun élément conducteur n'y est, par conséquent formé. On constate sur la figure 2 que des portions de bandes de connexion 48a, 48b, 48c et 46a sont formés respectivement à la périphérie des deuxièmes champs 138 et 132 mais, comme il n'existe pas de portion de bande de connexion correspondante dans le champ 34, aucune liaison électrique n'est établie entre les éléments des cellules correspondant aux champs 34 et aux champs 132 et 138. La cellule correspondant au champ 34 reste ainsi électriquement isolée.

Cette étape de formation du dernier niveau conducteur peut être effectuée comme décrit précédemment, c'est-à-dire par dépôt d'une couche de matériau conducteur tel que de l'aluminium par exemple, et d'une résine photosensible. L'insolation de la résine selon les motifs correspondant aux bandes de connexion, le développement de la résine, et la gravure du matériau conducteur non protégé permet de mettre en forme le dernier niveau conducteur. On peut noter qu'avantageusement l'insolation est effectuée champ après champ avec un équipement de photorépétition d'un type connu.

Le motif des éléments du dernier niveau conducteur peut aussi être défini par pelage du conducteur.

Dans ce cas, le conducteur est déposé sur une couche de résine mise en forme selon un motif complémentaire du motif des bandes de jonction à réaliser.

Les parties de la couche de conducteur correspondant audit motif complémentaire sont alors éliminées par pelage en attaquant la résine sous-jacente.

Comme on le voit sur la figure 2, l'étape de mise en forme de la dernière couche de conducteur pour la formation des bandes de jonction, peut être avantageusement être mise à profit pour réaliser les électrodes 14 dans les champs valides 132, 136, 138.

Ainsi, l'étape de "reconfiguration" du dispositif se confond avec l'étape de réalisation du dernier niveau conducteur des éléments constitutifs du dispositif.

La figure 2 illustre une application particulière de l'invention pour la réalisation d'un dispositif comportant une pluralité de puces servant de support pour des réactions électrochimiques.

Lorsqu'un signal d'adressage comportant une adresse d'électrode est envoyé simultanément à tous les circuits d'adressage valides de toutes les cellules valides du dispositif, l'électrode de chaque cellule correspondant à l'adresse d'électrode peut être portée à un potentiel apte à déclencher une réaction électrochimique.

La possibilité de déclencher sélectivement une réaction chimique peut être mise à profit pour former sélectivement des dépôts électrochimiques sur les électrodes.

Dans un autre domaine, le procédé de l'invention peut être mis à profit pour interconnecter des cellules de mémoire valides d'un dispositif à mémoires électroniques.

### REFERENCES DES DOCUMENTS CITES DANS LA PRESENTE DESCRIPTION

***(1)*** "A 4 Mbit Static RAM" de J. Trilhe, International Conference on Wafer Scale Integration, 1989, pp. 193-200.
***(2)*** "Laser Programmable Redundancy and Yield Improvement in a 64K DRAM" de R.T. Smith et al., IEEE Journal of solid-state circuits vol. SC-16, n°5, october 1981, pp. 506 à 514.
***(3)*** US-A-3 585 712

## Revendications

1. Procédé de fabrication et de reconfiguration d'un dispositif de microélectronique comportant sur un substrat une pluralité d'éléments (16) interconnectés, **caractérisé en ce qu'**il comporte les opérations successives suivantes :
a) réalisation de cellules (12) d'éléments sur un substrat (10), chaque cellule (12) comportant au moins un élément (16), les cellules d'éléments étant isolées électriquement les unes des autres et au moins un élément de chaque cellule présentant au moins un terminal de connexion (22a, 22b, 22c, 24a, 24b, 24c, 26a, 26b, 26c) pour la connexion des cellules d'éléments selon un plan de connexion déterminé,
b) test des cellules (12) pour distinguer des cellules valides dont les éléments sont valides, et des cellules comportant au moins un élément invalide,
c) formation par photolithographie de bandes de jonction (40a, 40b, 40c, 44a, 44b, 44c) en un matériau conducteur électrique reliant au moins un terminal de connexion d'au moins un élément d'une cellule valide avec au moins un élément d'une autre cellule valide, les bandes de jonction étant formées dans des champs d'insolation valides, sensiblement identiques (132, 136, 138), chaque champ d'insolation valide recouvrant respectivement une cellule valide et comprenant au moins une zone marginale (50, 52) de recouvrement avec au moins un champ voisin, la zone de recouvrement étant insolée à un motif de lithographie correspondant à au moins une portion de bande de jonction de sorte que chaque bande de connexion est réalisée selon un motif correspondant à la juxtaposition et au recouvrement partiel de motifs de champs d'insolation voisins.

2. Procédé selon la revendication 1, **caractérisé en ce que** le test des cellules comporte le test individuel de chaque élément (16).

3. Procédé selon la revendication 1, **caractérisé en ce que** la fabrication des bandes de jonction (40a, 40b, 40c, 44a, 44b, 44c) comporte :
- le dépôt sur l'ensemble du substrat d'une couche de matériau conducteur électrique recouvrant les éléments,
- le dépôt d'une couche de résine photosensible sur la couche de matériau conducteur électrique,
- l'insolation de la résine dans lesdits champs valides, à travers un masque, créant par recouvrement des champs valides des motifs correspondant aux bandes de jonction,
- le développement de la résine, pour l'éliminer en dehors de régions correspondant aux bandes de jonction,
- la gravure de la couche de matériau conducteur mise à nu en laissant subsister les bandes de jonction.

4. Procédé selon la revendication 1, **caractérisé en ce que** la fabrication des bandes de jonction (40a, 40b, 40c, 44a, 44b, 44c) comporte :
- le dépôt sur l'ensemble du substrat d'une couche de résine photosensible,
- insolation de la résine dans lesdits champs valides, à travers un masque, créant par recouvrement des champs valides des motifs correspondant aux bandes de jonction,
- développement de la résine pour l'éliminer dans des régions correspondant aux bandes de jonction,
- dépôt sur l'ensemble du substrat d'une couche de matériau conducteur électrique,
- attaque de la résine et élimination par pelage du matériau conducteur électrique en dehors des régions correspondant aux bandes de jonction.

5. Procédé selon l'une quelconque des revendications 3 et 4, **caractérisé en ce qu'**on effectue l'insolation champ après champ, avec un équipement de photorépétition.

6. Procédé selon l'une quelconque des revendications précédentes dans lequel les éléments sont réalisés dans une pluralité de niveaux de matériau conducteur et dans lequel les bandes de jonction sont formées dans un des niveaux conducteurs de ladite pluralité de niveaux.

7. Procédé selon l'une quelconque des revendications précédentes dans lequel le dispositif comporte des cellules (12) identiques, ces cellules identiques étant réalisées par photorépétition de motifs de lithographie.

8. Procédé selon la revendication 6, **caractérisé en ce que** chaque cellule comporte des électrodes (14) et éventuellement un circuit de multiplexage (16) des électrodes.

## Patentansprüche

1. Verfahren zur Herstellung und Rekonfiguration einer mikroelektronischen Vorrichtung mit, auf einem Substrat, einer Vielzahl miteinander verbundener Elemente (16), **dadurch gekennzeichnet, dass** es die folgenden sukzessiven Schritte umfasst:
a) Herstellung von Elemente-Zellen (12) auf einem Substrat (10), wobei jede Zelle (12) wenigstens ein Element (16) umfasst, die Elemente-Zellen elektrisch voneinander isoliert sind und wenigstens ein Element jeder Zelle wenigstens einen Verbindungsanschluss (22a, 22b, 22c, 24a, 24b, 24c, 26a, 26b, 26c) aufweist, zur Verbindung von Elemente-Zellen nach einem bestimmten Verbindungsplan,
b) Test der Zellen (12), um gültige Zellen, deren Elemente gültig sind, und Zellen mit wenigstens einem ungültigen Element zu unterscheiden,
c) Bildung von Verbindungsstreifen (40a, 40b, 40c, 44a, 44b, 44c) aus einem elektrisch leitfähigen Material durch Photolithographie, die wenigstens einen Verbindungsanschluss von wenigstens einem Element einer gültigen Zelle mit wenigstens einem Element einer anderen gültigen Zelle verbinden, wobei die Verbindungsstreifen in gültigen Bestrahlungs- bzw. Belichtungszonen gebildet werden, die im Wesentlichen identisch sind (132, 136, 138), und jede gültige Bestrahlungs- bzw. Belichtungszone jeweils eine gültige Zelle und wenigstens eine Randzone (50, 52) abdeckt, mit Überlappung in wenigstens ein benachbartes Feld, wobei die Überlappungszone mit einem Lithographiemuster bestrahlt bzw. belichtet wird, das wenigstens einem Teil des Verbindungsstreifens entspricht, so dass jeder Verbindungsstreifen nach einem Muster realisiert wird, das der Aneinanderreihung und partiellen Überlappung von Mustern benachbarter Bestrahlungs- bzw. Belichtungsfelder entspricht.

2. Verfahren nach Anspruch 1, **dadurch gekennzeichnet, dass** der Test der Zellen den Einzeltest jedes Elements (16) umfasst.

3. Verfahren nach Anspruch 1, **dadurch gekennzeichnet, dass** die Herstellung der Verbindungsstreifen (40a, 40b, 40c, 44a, 44b, 44c) umfasst:
- das Abscheiden einer Schicht aus elektrisch leitfähigem Material auf dem gesamten Substrat, die die Elemente bedeckt,
- das Abscheiden einer Photoresistschicht auf der Schicht aus elektrisch leitfähigem Material,
- das Belichten des Resists in den genannten gültigen Feldern durch eine Maske hindurch, die durch Überlappung der gültigen Felder Muster schafft, die den Verbindungsstreifen entsprechen,
- das Entwickeln des Resists, um es außerhalb der den Verbindungsstreifen entsprechenden Bereichen zu entfernen,
- das Ätzen der freigelegten Schicht aus leitfähigem Material, wobei die Verbindungsstreifen zurückbleiben.

4. Verfahren nach Anspruch 1, **dadurch gekennzeichnet, dass** die Herstellung der Verbindungsstreifen (40a, 40b, 40c, 44a, 44b, 44c) umfasst:
- das Abscheiden einer Photoresistschicht auf dem gesamten Substrat,
- das Belichten des Resists in den genannten gültigen Feldern durch eine Maske hindurch, die durch Überlappung der gültigen Felder Muster schafft, die den Verbindungsstreifen entsprechen,
- das Entwickeln des Resists, um es außerhalb der den Verbindungsstreifen entsprechenden Bereichen zu entfernen,
- das Abscheiden einer Schicht aus elektrisch leitfähigem Material auf dem gesamten Substrat, die die Elemente bedeckt,
- das Angreifen des Resists und das Entfernen des elektrisch leitfähigen Materials durch Abschälen außerhalb der den Verbindungsstreifen entsprechenden Bereiche.

5. Verfahren nach einem der Ansprüche 3 und 4, **dadurch gekennzeichnet, dass** man die Belichtung Feld für Feld durchführt, mit einer Photorepetitionsausrüstung.

6. Verfahren nach einem der vorangehenden Ansprüche, bei dem die Elemente in einer Vielzahl von Niveaus aus leitfähigem Material realisiert werden und bei dem die Verbindungsstreifen in leitfähigen Niveaus der genannten Vielzahl von Niveaus gebildet werden.

7. Verfahren nach einem der vorangehenden Ansprüche, bei dem die Vorrichtung identische Zellen (12) umfasst, wobei diese identischen Zellen durch Photorepetition von Lithographiemustern realisiert werden.

8. Verfahren nach Anspruch 6, **dadurch gekennzeichnet, dass** jede Zelle Elektroden (14) umfasst und eventuell eine Elektroden-Multiplexschaltung (16).

## Claims

1. Process of manufacturing and reconfiguration of a microelectronic device containing, on a substrate, a plurality of interconnected elements (16), **characterized in that** it includes the following successive operations:
a) manufacturing of cells (12) of elements on a substrate (10), each cell (12) containing at least one element (16), the cells of elements being electrically isolated from each other and at least one element of each cell presenting at least one connection terminal (22a, 22b, 22c, 24a, 24b, 24c, 26a, 26b, 26c) for connecting the cells of elements according to a given connection plan,
b) test of the cells (12) in order to distinguish valid cells whose elements are valid from cells containing at least one invalid element,
c) formation by photolithography of junction bands (40a, 40b, 40c, 44a, 44b, 44c) in an electrical conductive material connecting at least one connection terminal of at least one element of a valid cell with at least one element of another valid cell, the junction bands being formed in valid, substantially identical insolation fields (132, 136, 138), each valid insolation field covering respectively a valid cell and comprising at least one marginal overlapping cone (50, 52) with at least one neighbouring field, the overlapping zone being insolated with a lithography pattern corresponding to at least one junction band portion, so that each connection band is implemented according to a pattern corresponding to the juxtaposing and partial overlapping of neighbouring insolation field patterns.

2. Process according to claim 1, **characterized in that** the test of the cells includes the individual testing of each element (16).

3. Process according to claim 1, **characterized in that** the manufacturing of the junction bands (40a, 40b, 40c, 44a, 44b, 44c) comprises:
- the deposition on the entire substrate of a layer of electrical conductive material covering the elements,
- the deposition of a layer of photosensitive resin on the layer of electrical conductive material,
- the insolation of the resin in said valid fields, through a mask, creating, by overlapping of the valid fields patterns corresponding to the junction bands,
- the processing of the resin, in order to eliminate its presence outside regions corresponding to the junction bands,
- the etching of the exposed layer of conductive material by leaving the junction bands intact.

4. Process according to claim 1, **characterized in that** the manufacturing of the junction bands (40a, 40b, 40c, 44a, 44b, 44c) comprises:
- the deposition on the entire substrate of a layer of photosensitive resin,
- the insolation of the resin in said valid fields, through a mask, creating, by overlapping of the valid fields, patterns corresponding to the junction bands,
- the processing of the resin, in order to eliminate its presence outside regions corresponding to the junction bands,
- the deposition on the entire substrate of a layer of electrical conductive material,
- the etching of the resin and the elimination by lift off of the electrical conductive material outside the regions corresponding to the junction bands.

5. Process according to either of the claims 3 or 4, **characterized in that** insolation is carried out valid field by valid field, with photorepetition equipment.

6. Process according to any one of the preceding claims, in which the elements are manufactured in a plurality of levels of conductive materials and in which the junction bands are formed in one of the conductive levels of said plurality of levels.

7. Process according to any one of the preceding claims, in which the device includes identical cells (12), these identical cells being manufactured by photorepetition of lithographic patterns.

8. Process according to claim 6, **characterized in that** each cell includes electrodes (14) and, if required, a multiplexing circuit (16) of the electrodes.
